(19) Europäisches Patentamt
European Patent Office
Office européen des brevets

(11) Veröffentlichungsnummer: **0 167 777**
**B1**

(12) # EUROPÄISCHE PATENTSCHRIFT

(45) Veröffentlichungstag der Patentschrift: **25.01.89**

(21) Anmeldenummer: **85106565.6**

(22) Anmeldetag: **29.05.85**

(51) Int. Cl.⁴: **C 08 F 220/24,** C 08 F 220/30, C 08 F 220/36, G 03 F 7/10 // (C08F220/24, 220:30, 220:36), (C08F220/30, 220:24), (C08F220/36, 220:24)

(54) **Perfluoralkylgruppen aufweisende Copolymere, sie enthaltende Reproduktionsschichten und deren Verwendung für den wasserlosen Offsetdruck.**

(30) Priorität: **08.06.84 DE 3421526**

(43) Veröffentlichungstag der Anmeldung: **15.01.86 Patentblatt 86/3**

(45) Bekanntmachung des Hinweises auf die Patenterteilung: **25.01.89 Patentblatt 89/4**

(84) Benannte Vertragsstaaten: **CH DE FR GB LI**

(56) Entgegenhaltungen:
**EP-A-0 037 094**
**EP-A-0 096 845**
**GB-A-1 043 504**
**US-A-3 629 197**

**Die Akte enthält technische Angaben, die nach dem Eingang der Anmeldung eingereicht wurden und die nicht in dieser Patentschrift enthalten sind.**

(73) Patentinhaber: **HOECHST AKTIENGESELLSCHAFT, Postfach 80 03 20, D-6230 Frankfurt am Main 80 (DE)**

(72) Erfinder: **Müller, Werner H. Dr. Dipl.- Chem., 22 Coveside Ct., East Greenwich, R.I. 02818 (US)**
Erfinder: **Schneller, Arnold, Dr. Dipl.- Chem., Asternweg 41, D-6500 Mainz 21 (DE)**

**EP 0 167 777 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1989

**Beschreibung**

Die Erfindung betrifft Perfluoralkylgruppen aufweisende Copolymere und ein Verfahren zu deren Herstellung; außerdem betrifft sie strahlungsempfindliche Reproduktionsschichten, die diese Copolymere als Bindemittel enthalten, und deren Verwendung für den wasserlosen Offsetdruck.

Beim wasserlosen Flachdruck, insbesondere Offsetdruck wird - im Unterschied zum üblicherweise eingesetzten Offsetdruck - beim Drucken die Differenzierung in Bild- und Nichtbildstellen nicht durch das gleichzeitige Einwirken von Wasser oder wasserhaltigen Flüssigkeiten einerseits und Druckfarbe andererseits bewirkt, sondern die Differenzierung erfolgt in der Regel durch eine unterschiedliche Wechselwirkung zwischen farbannehmenden bzw. oleophilen und (nicht-wasserfeuchten) farbabweisenden bzw. oleophoben Stellen auf einer Druckplattenoberfläche mit der Druckfarbe. Aus dem Stand der Technik sind dazu beispielsweise die folgenden Druckschriften bekannt:

In der DE-C-1 571 890 (= US-A-3 677 178) wird eine Druckplatte beschrieben, die auf einem Trägermaterial aus einem Metall, einem Kunststoff oder Papier eine Schicht aus einem hydrophoben und oleophoben Silikonkautschuk und eine strahlungsempfindliche Reproduktionsschicht in dieser oder der umgekehrten Reihenfolge aufweist. Die Reproduktionsschicht enthält als strahlungsempfindliche Verbindung Ammoniumdichromat, Formaldehydkondensate von Di-phenylamin-4-diazoniumsalzen oder Polyvinylcinnamat. Die beim Drucken farbführenden Stellen sind entweder freigelegte Teile des Trägermaterials oder durch das Bestrahlen gehärtete Teile der Reproduktionsschicht.

Die Druckplatte gemäß der DE-B-1 671 637 (= US-A-3 511 178 und 3 682 633) weist auf einem Trägermaterial zunächst eine strahlungsempfindliche Reproduktionsschicht und darauf eine Beschichtung auf, die gegenüber Druckfarben einen geringeren Ablösewert (geringere adhäsive Wechselwirkung) als das Trägermaterial hat. Die letztgenannte Beschichtung besteht entweder aus einem Polysiloxan (Silikonelastomer) oder einer fluorhaltigen organischen Verbindung wie einem Homopolymer aus dem Methacrylsäureester des Perfluoroctanols.

Weitere Ausgestaltungen von Druckplatten für den wasserlosen Offsetdruck bzw. von dafür geeigneten Verbindungen sind beispielsweise den folgenden Druckschriften zu entnehmen:

Aus der DE-A-2 354 838 (= US-A-3 953 212) ist die Kombination einer strahlungsempfindlichen Verbindung mit einem Silikonkautschuk in einer Schicht auf einem der üblichen Trägermaterialien bekannt. Die Druckplatte gemäß der DE-B-2 422 428 (= GB-A-1 464 123) enthält in einer Schicht ein photopolymerisierbares Polysiloxan und einen Photosensibilisator.

In der DE-A-2 524 562 (= GB-A-1 501 128) werden strahlungsempfindliche Beschichtungen beschrieben, die ein aromatisches Diazoniumkation, ein Anion einer Perfluoralkylgruppen aufweisenden Carbon- oder Sulfonsäure und gegebenenfalls ein polymeres organisches Bindemittel enthalten. Von dieser Schicht soll nach dem Bestrahlen direkt, d. h. ohne Entwicklungsschritt, gedruckt werden können.

In einer oleophoben Beschichtung enthalten die Druckplatten nach der DE-A-2 648 278 (= US-A-4 087 584) ein flourhaltiges Homo- oder Copolymerisat mit Monomereneinheiten, die sich von Acrylsäure- oder Methacrylsäureestern mit Perfluoralkyl-, 4-Perfluoralkoxy-benzolyloxy-alkyl- oder Perflouralkan-sulfonamidoalkyl-Gruppen ableiten. Bei Copolymerisaten ist der Anteil der fluorhaltigen Monomereneinheiten größer als 75 %. Diese oleophobe Beschichtung befindet sich entweder direkt auf einem Trägermaterial und Bildbezirke werden auf die Beschichtung aufgetragen oder sie befindet sich oberhalb einer elektrophotographischarbeitenden Reproduktionsschicht, so daß dann auf der oleophoben Beschichtung Tonerbilder erzeugt werden.

Aus der US-A-3 910 187 sind verschiedene Möglichkeiten bekannt, aus üblichen Photopolymerdruckplatten (d. h. Druckplatten aus einem Trägermaterial und einer Reproduktionsschicht mit einem Gehalt an photopolymerisierbaren Verbindungen) durch Aufbringen einer Zwischen- oder Abschlußschicht Druckplatten für die Anwendung im wasserlosen Offsetdruck zu erzeugen. Diese Zwischen- oder Abschlußschichten enthalten entweder Perfluoralkylgruppen aufweisende Carbon-, Sulfon-, Phosphonsäuren und Amine oder Polymerisate aus Perfluoralkylgruppen aufweisenden Acrylsäure- oder Methacrylsäureestern, Maleinsäurediestern, Vinylethern, Carbonsäurevinylestern, Sulfonamidoallylestern u. ä.; die Polymerisate werden entweder bereits vor dem Aufbringen auf die Druckplatte aus den genannten Monomeren oder direkt auf den Druckplatten durch Photopolymerisation hergestellt.

Der EP-A-0 037 094 ist zu entnehmen, daß strahlungsempfindliche Polymere (u.a. für den Einsatz als Beschichtung für Druckplatten) hergestellt werden können, die Copolymerisate aus a) Acrylsäure- oder Methacrylsäure-perfluoralkylestern und b) Acrylsäure- oder Methacrylsäure-azidobenzoyloxy-alkylestern sind. Strahlungsempfindliche Reproduktionsschichten können neben diesen Copolymerisaten auch noch alkalischentwickelbare organische Bindemittel und übliche Hilfsmittel enthalten. Nach der Bestrahlung und Entwicklung wird auf dem Trägermaterial ein Reliefbild erzeugt. In der EP-A-0 040 841 werden strahlungsempfindliche Polymere beschrieben, die Copolymerisate aus a) Monomeren mit endständigen Perfluoralkylgruppen und endständigen ethylenisch-ungesättigten gruppen und b) Monomeren mit strahlungsempfindlichen Gruppen und ethylenisch-ungesättigten Gruppen sind. Zu der ersten Gruppe von Monomeren zählen beispielsweise Acrylsäure- oder Methacrylsäure-perfluoralkylester und zu der zweiten Gruppe beispielsweise Methacrylsäureazidobenzoyloxyalkylester, Acrylsäure-cinnamoyloxy-alkylester, Methacrylsäure-benzoyl-phenylester oder Methacrylsäure-cinnamoyl-phenylester. Aus der EP-A-0 096 845 sind strahlungsempfindliche Polymere bekannt, die Copolymerisate aus a) Acrylsäure- oder Methacrylsäure-2-perfluoralkoxy-2-fluor-ethyl-1-estern oder verwandten Verbindungen, b) Monomeren mit strahlungsempfindlichen Gruppen und ethylenisch-ungesättigten Gruppen und c) gegebenenfalls weiteren fluorfreien copolymerisierbaren Vinylmonomeren sind.

Bei den bisher für die Herstellung von Druckformen für den wasserlosen Offsetdruck bekanntgewordenen Reproduktionsschichten müssen häufig organische Lösemittel wie 2-Butoxyethanol-(1), Ethylenglykolmonoethylether, Methylenchlorid, Dioxan oder Hexafluor-m-Xylol im Entwicklungsschritt eingesetzt werden, so daß aufwendige Redestillationsanlagen u. ä. für eine umweltfreundliche Aufarbeitung erforderlich sind. Außerdem sind die Ausgangskomponenten oftmals nur schwer (d. h. zum Beispiel über mehrere Stufen) zu synthetisieren, so daß sie für eine großtechnische Anwendung nicht oder nur in untergeordnetem Maße in Betracht gezogen werden können. Mit Reproduktionsschichten, die kein Bindemittel enthalten und/oder nach deren Bestrahlung kein zusätzlich differenzierender Entwicklungsschritt durchgeführt wird, sind im allgemeinen keine höheren Druckauflagen zu erzielen. Bindemittel enthaltende Reproduktionsschichten, die als strahlungsempfindliche Komponente bereits eine fluoralkylgruppenhaltige Verbindung aufweisen, sind nicht ohne weiteres herzustellen, da die üblichen Bindemittel häufig nicht oder nur erschwert mit diesen Verbindungen zu einer homogen-wirkenden Beschichtung vereinigt werden können. Oftmals treten die Auswirkungen der möglichen Unverträglichkeit der beiden Hauptkomponenten von Reproduktionsschichten, nämlich der strahlungsempfindlichen Komponente und der Bindemittelkomponente, nicht bereits beim Herstellen der Beschichtungsmasse, sondern erst bei bzw. nach ihrer Trocknung, d. h. der Entfernung des Löse- bzw. Dispergiermittels auf.

Aufgabe der vorliegenden Erfindung ist es deshalb, neue Fluoralkylgruppen enthaltende Copolymere, insbesondere für den Einsatz auf dem Gebiet des wasserlosen Offsetdrucks, zu synthetisieren, die eine gute Verträglichkeit mit anderen Komponenten aufweisen, möglichst aus im Handel erhältlichen Ausgangsstoffen (Edukten) hergestellt und in Reproduktionsschichten nach der Bestrahlung möglichst mit wäßrigen Lösungen (insbesondere mit wäßrig-alkalischen Lösungen) entwickelt werden können.

Gegenstand der Erfindung sind Perfluoralkylgruppen enthaltende Copolymere, hergestellt aus mindestens zwei unterschiedlichen Monomeren mit je einer polymerisierbaren endständigen ethylenisch-ungesättigten Gruppe, wobei eines der beiden Monomeren eine Perfluoralkyl - oder Fluoralkenyl gruppe aufweist, die dadurch gekennzeichnet sind, daß

(a) 10 bis 90 Gew.-% Acryloyl- oder Methacryloylgruppen und phenolische OH-Gruppen enthaltende Monomere der allgemeinen Formel (I)

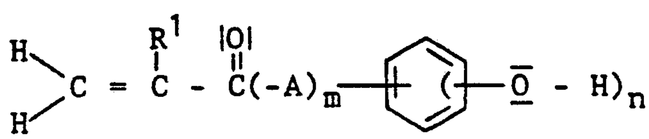

(I)

in der $R^1$ = H oder $CH_3$; n = 1,2 oder 3; m = 0 oder 1

und

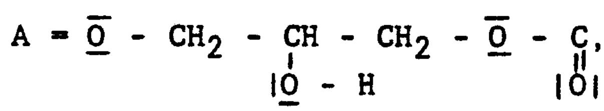

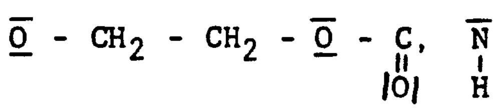

oder

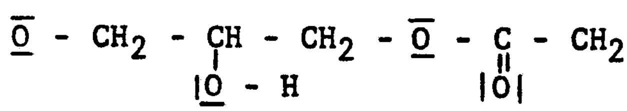

bedeuten und

(b) 90 bis 10 Gew.-% Acryloyloxy-, Methacryloyloxy- oder Vinylgruppen und eine Perfluoralkylgruppe enthaltende Monomere der allgemeinen Formeln (II) oder (III)

(II) 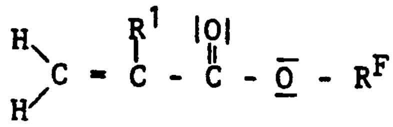

(III) 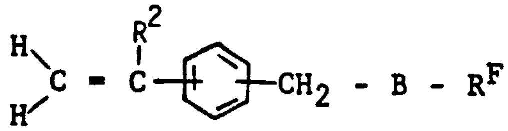

in denen $R^1$ die obige Bedeutung besitzt, $R^2$ = H oder Alkyl von $C_1$ bis $C_5$, B = $\underline{O}$ oder $NR^2$, $R^F$ = $F(C_wF_{2w})(-CH_2)_z$ oder $F(C_{w-1}F_{2w-2})$ - CF=CH, wobei die Difluormethylengruppen gegebenenfalls auch über Etherbrücken verknüpft sein können, w = 5 bis 15 und z = 0 bis 5 bedeuten, wobei sich die Prozentangaben auf die Gesamtmenge an Monomeren beziehen,

copolymerisiert worden sind.

In bevorzugten Ausführungsformen werden die Copolymeren (Copolymerisate) aus 10 bis 90 % der Monomeren-Komponente (a) und 90 bis 10 % der Monomeren-Komponente (b), insbesondere 20 bis 80 % und 80 bis 20 %, hergestellt, und in den allgemeinen Formeln bedeutet m = 1,

$$A = \overline{\underline{O}} - CH_2 - \underset{|\underline{O} - H}{CH} - CH_2 - \overline{\underline{O}} - \underset{\|\,|O|}{C}$$ und n = 1 [bezogen auf Formel (I)], w = 6 bis 12, z = 0 bis 2 und B = $\underline{O}$ [bezogen auf die Formeln (II) und (III)].

Dabei befinden sich die genannten Substituentengruppen der Verbindungen der Formeln (I) und (III) an verschiedenen C-Atomen der Moleküle dieser Verbindungen, bei der Verbindung (II) müssen sie dies jedoch nicht; und die Perfluoralkylgruppe ist direkt oder über ein unverzweigtes oder verzweigtes, gesättigtes oder ungesättigtes Alkylenzwischenglied mit 1 bis 5 C-Atomen mit der Esterfunktion in der Formel (II) oder mit der Ether- bzw. Amidfunktion in der Formel (III) verbunden. Die fluorierten Gruppen $R^F$ sind ungesättigt oder gesättigt, verzweigt oder unverzweigt und weisen im allgemeinen 5 bis 15 C-Atome, insbesondere 6 bis 12 C-Atome, auf; sie sind bevorzugt unverzweigte Molekülreste und haben maximal zwei Doppelbindungen pro Molekülrest.

Die Molekularmassen der erfindungsgemäßen Copolymeren liegen im allgemeinen bei etwa 1 000 bis 100 000, insbesondere 3 000 bis 50 000. Die Copolymerisation der Komponenten (a) und (b) wird unter den üblichen Reaktionsbedingungen durchgeführt, beispielsweise in Anwesenheit eines Polymerisationsinitiators wie Azoisobuttersäurenitril in einem organischen Lösemittel wie Butanon-2 bei erhöhter Temperatur von etwa 40 bis 100°C während eines Zeitraums von etwa 1 bis 12 h; neben dieser bevorzugten Lösungspolymerisation ist aber auch eine Suspensions-, Emulsions- oder Massenpolymerisation möglich, die ebenfalls in der Regel in Gegenwart eines Polymerisationsinitiators ablaufen. Es ist in einigen Fällen auch eine Photopolymerisation der Monomeren in Gegenwart eines Photoinitiators möglich.

Im Regelfall muß auch die Komponente (a) zunächst synthetisiert werden, dazu wird insbesondere eine Hydroxybenzoesäure, eine (Hydroxy-phenyl)-essigsäure oder ein Aminophenol mit einem Hydroxyalkylacrylat, Glycidylacrylat, dem entsprechenden Methacrylat oder einer Acrylsäure, einem Acrylsäurederivat (z. B. Ester oder Halogenid) oder der entsprechenden Methacrylverbindung zum Ester oder Amid umgesetzt. Ein bevorzugtes Beispiel für diese Reaktion ist die Herstellung von Monomeren der allgemeinen Formel (VII), die eine bevorzugte Ausführungsform der allgemeinen Formel (I) darstellen, in der m = 1 und A

$$\overline{\underline{O}} - CH_2 - \underset{|\underline{O} - H}{CH} - CH_2 - \overline{\underline{O}} - \underset{\|\,|O|}{C}$$

oder

$$\overline{\underline{O}} - CH_2 - CH_2 - \overline{\underline{O}} - \underset{\|\,|O|}{C}$$

darstellen, durch Veresterung von Hydroxybenzoesäure der allgemeinen Formel (IV) mit Hydroxyalkylacrylat oder Glycidylacrylat bzw. dem entsprechenden Methacrylat der allgemeinen Formeln (V) und (VI):

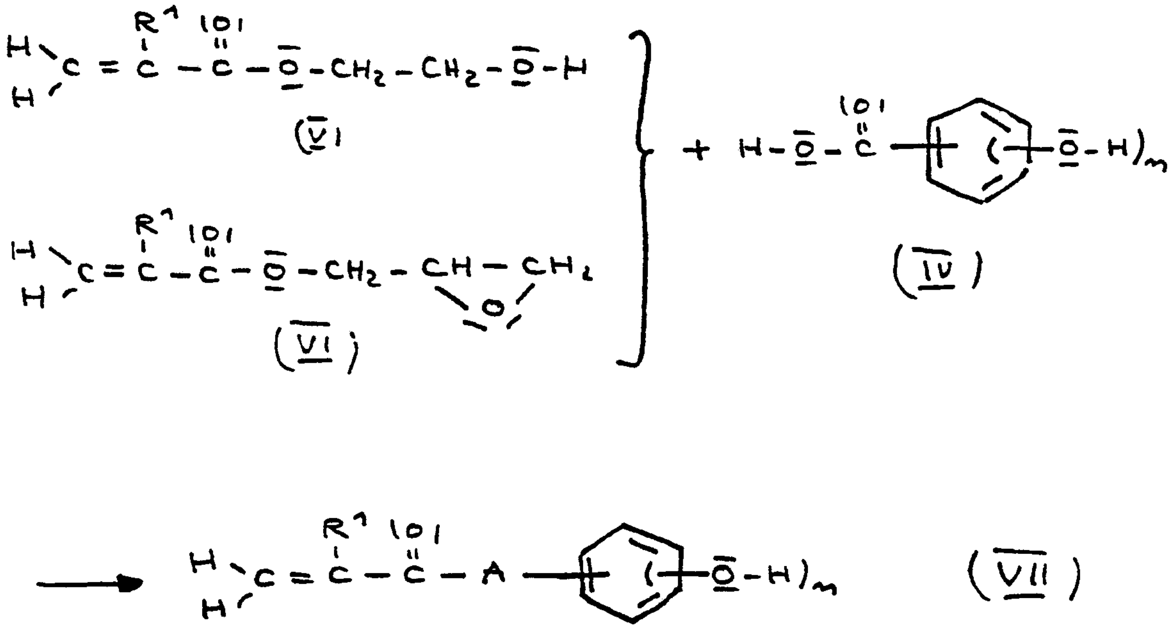

(V) (VI) (IV) (VII)

Ein anderes Beispiel für die Synthese der Komponente (a) ist die angeführte Umsetzung eines Aminophenols der allgemeinen Formel (VIII) mit einer Acryl- oder Methacrylverbindung der allgemeinen Formel (IX) zu den Amiden (X):

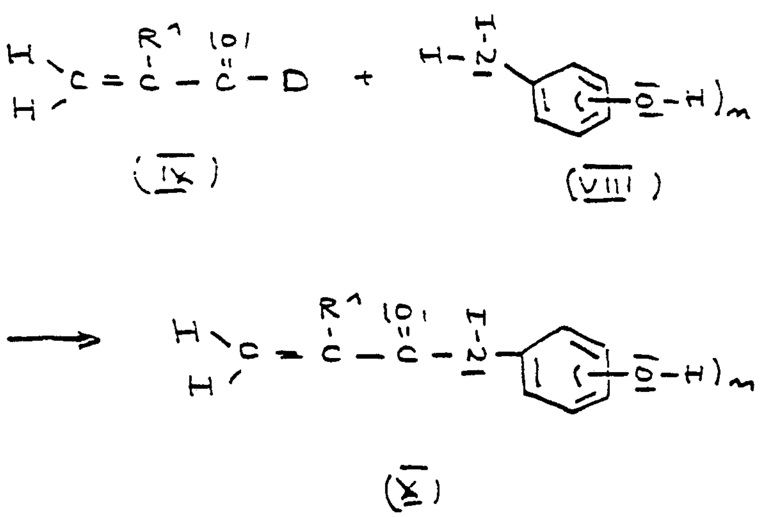

(IX) (VIII) (X)

D bedeutet in der Formel IX ein Halogenatom.

Beispiele für die Komponente (b) sind einerseits Acrylate oder Methacrylate von Perfluoralkoholen bzw. Perfluoralkyl-alkanolen wie 1,1-Dihydro-perfluoroctanoll-1, Per-fluoroctanol-1, 1,1,2,2-Tetrahydro-perfluoroctanol-1, 1,1,2,2-Tetrahydro-perfluordecanol-1, 1,2,2,-Tetrahydro-perfluordodecanol-1, 1,1,2,2-Tetrahydro-perfluortetradecanol-1 und 9-Trifluormethyl-1,1,2,2-tetrahydro-perfluordecanol-1 oder Perfluoralkylenoxidgruppen aufweisenden Perfluoralkyl-alkanolen bzw. Perfluoralkoholen wie 3,3,3,-Trifluor-2-(perfluorpropyloxy-bis-perfluorpropylenoxy)-2-fluor-propanol-1

$$[HO-CH_2-\underset{|\atop CF_3}{CF}(OCF_2\underset{|\atop CF_3}{CF})_2OCF_2CF_2CF_3],$$

andererseits Vinylbenzylether der vorstehend aufgeführten Alkohole.

Wenn es spezielle Anwendungsgebiete erfordern, können außer den genannten Monomeren-Komponenten (a) und (b) auch noch andere Arten an Monomeren eingesetzt werden. Beispiele für solche von (I), (II) und (III) verschiedenen Monomeren sind Acrylsäure, Methacrylsäure, deren Ester, Alkansäurevinylester, Styrole, Vinylhalogenide, Vinylidenhalogenide, Vinylalkylketone, Acrylamide und Diene wie 2,3-Dihalogen-1,3-butadien. Solche Monomeren sollen im Copolymeren einen Anteil von 40 % jedoch nicht überschreiten.

Die erfindungsgemäßen, Perfluoralkylgruppen enthaltenden Copolymeren können zur Herstellung von hydrophoben und oleophoben Massen wie Lacken, Imprägnierungen oder Beschichtungen, insbesondere aber in strahlungsempfindlichen Reproduktionsschichten verwendet werden. Ein weiterer Gegenstand der Erfindung sind deshalb strahlungsempfindliche Reproduktionsschichten mit einem Gehalt an (c) mindestens einer strahlungsempfindlichen Verbindung und (d) mindestens einem organischen polymeren Bindemittel, die dadurch gekennzeichnet sind, daß die Komponente (d) ein Copolymeres aus den vorstehend definierten Komponenten (a) und (b) ist. Insbesondere werden als Bindemittel solche Copolymere eingesetzt, die in wäßrig-alkalischen Lösungen löslich sind. Bei dem Einsatz der erfindungsgemäßen Copolymeren in Reproduktionsschichten als Komponente (d) werden als Komponente (c) insbesondere ebenfalls Fluor, bevorzugt Perfluoralkylgruppen enthaltende Verbindungen, gewählt, da dies häufig zu einer besseren Vermischbarkeit der Komponenten und damit zu einer auch optisch gleichmäßigeren Beschichtung führt. Neben den Copolymeren gemäß der Erfindung können die Reproduktionsschichten auch noch von diesen verschiedene Bindemittel enthalten, die jedoch maximal 40 % des Bindemittelanteils ausmachen sollten.

Als Beispiele für geeignete Bindemittel seien genannt: Polyamide, Polyvinylester, Polyvinylacetale, Polyvinylether, Polyacrylsäureester, Polymethacrylsäureester, Polyester, Alkydharze, Polyacrylamid, Polyvinylalkohol, Polyethylenoxid, Polydimethylacrylamid, Polyvinylmethylformamid, Polyvinylmethylacetamid sowie Mischpolymerisate der Monomeren, die die aufgezählten Homopolymerisate bilden. Ferner kommen als Bindemittel Naturstoffe oder umgewandelte Naturstoffe in Betracht, z. B. Gelatine oder Celluloseether.

Mit Vorteil werden Bindemittel verwendet, die in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, $-PO_3H_2$, $-SO_3H$, $-SO_2NH_2$, $-SO_2-NH-CO-$. Als Beispiele hierfür seien genannt: Maleinatharze, Polymerisate aus N-(p-Tolylsulfonyl)carbaminsäure-(β-methacryloyloxyethyl)-ester und Mischpolymerisate dieser und ähnlicher Monomeren mit anderen Monomeren, ferner Methylmethacrylat-Methacrylsäure-Copolymerisate oder Mischpolymerisate aus Methacrylsäure, Alkylmethacrylaten und Methylmethacrylat und/oder Styrol, Acrylnitril u.a.

In der Komponente (c), d. h. in der Komponente mit den strahlungsempfindlichen Verbindungen, können grundsätzlich alle Verbindungen eingesetzt werden, die in Reproduktionsschichten nach dem Bestrahlen (Belichten) mit einer nachfolgenden Entwicklung eine bildmäßige Fläche liefern, von der gedruckt werden kann.

Neben den auf vielen Gebieten verwendeten Silberhalogenide enthaltenden Schichten sind auch verschiedene andere bekannt, wie sie z. B. in "Light-Sensitive Systems" von Jaromir Kosar, John Wiley & Sons Verlag, New York 1965 beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazo-chinone wie Naphthochinondiazide, p-Diazo-chinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten.

Besonders bevorzugt sind als strahlungsempfindliche Verbindungen bzw. Systeme in der Komponente (c) der Reproduktionsschichten die in den gleichzeitig eingereichten und veröffentlichten EP-A-167 778 und 167 779 beschriebenen Verbindungen. In der EP-A-167 779 (DE-A-3 421 511) werden Verbindungen mit mindestens zwei polymerisierbaren (Meth)acryloylgruppen und mindestens einer über eine funktionelle Gruppe, insbesondere eine Ester- oder Amidgruppe, an das Molekül gebundenen Perfluoralkylgruppe beschrieben. Sie können beispielsweise aus hydroxylgruppenhaltigen Acrylaten oder Methacrylaten und Perfluoralkylgruppen aufweisenden Carbonsäurechloriden in Gegenwart eines Amins oder aus Perfluoralkylgruppen enthaltenden Carbonsäurederivaten und reaktiven Acryloyloxy- oder Methacryloyloxyverbindungen hergestellt werden. Oligomere Verbindungen lassen sich zusätzlich aus den genannten Verbindungen durch Verknüpfung mit beispielsweise Diisocyanaten sythetisieren. Ein Beispiel für eine derartige Verbindung ist ein Reaktionsprodukt aus Perfluoroctansäurechlorid und Pentaerythritrriacrylat. Diese Verbindungen ergeben in Kombination mit Photoinitiatoren photopolymerisierbare Gemische.

In der EP-A-167 778 (DE-A-3 421 471) werden Perfluoralkylgruppen aufweisende 1,2-Naphthochinondiazidverbindungen der allgemeinen Formel I beschrieben

$$(R_FW)_p - \overset{R^1}{\overset{|}{Ar}}(-OD)_n$$

worin

Ar einen ein- bis dreikernigen aromatischen Rest, bevorzugt einen Benzophenonrest,

D einen 1,2-Naphthochinon-2-diazid-4- oder einen 1,2-Naphthochinon-2-diazid-5-sulfonylrest,

$R_F$ einen Perfluoralkylrest mit 5 bis 15 Kohlenstoffatomen,

W eine Einfachbindung oder eine der Gruppen

| | |
|---|---|
| $-(CH_2)_mCOO-$ | $-(CH_2)_mOOC-CHR^2-O-$ |
| $-(CH_2)_mO-C_oH_{2o}-COO-$ | $-(CH_2)_mOOC-$ |
| $-(CH_2)_mOOC-C_oH_{2o}-COO-$ | $-(CH_2)_mSO_2NH-$ |
| $-(CH_2)_mOOC-CH=CH-COO-$ | $-C_6H_4SO_2NH-$ |
| $-(CH_2)_mCO-$ | $-(CH_2)_mCONH-$ |
| $-(CH_2)_mSO_3-$ | $-(CH_2)_mOOC-C_oH_{2o}-CONH-$ |
| $-C_6H_4SO_3-$ | $-(CH_2)_mOOC-CH=CH-CONH$, |

$R^1$ ein Wasserstoff- oder Halogenatom, eine Alkyl-oder Alkoxygruppe mit 1 bis 5 Kohlenstoffatomen, eine Acetyl- oder Propionylgruppe,

$R^2$ eine Alkylgruppe mit 1 bis 12, bevorzugt bis 3, Kohlenstoffatomen,

m O oder eine Zahl von 1 bis 6,

n eine Zahl von 1 bis 3,

o eine Zahl von 1 bis 12 und

p eine Zahl von 1 bis 3, bevorzugt 1,

bedeutet.

Die Verbindungen werden hergestellt durch Umsetzen einer aromatischen Polyhydroxyverbindung mit einer Verbindung $R^FWX$, worin X ein Halogenatom ist, und einem Naphthochinondiazidsulfonylhalogenid.

Von der Komponente (c) enthalten die Reproduktionsschichten im allgemeinen 5 bis 50 %, im Falle des Einsatzes von photopolymerisierbaren Verbindungen bzw. Systemen auch bis zu 80 %, und von der Komponente (d) 95 bis 50 % [oder auch bis 20 % beim Einsatz von photopolymerisierbaren Verbindungen als Komponente (c)].

Die genannten Reproduktionsschichten können außer den Komponenten (c) und (d) noch eine Reihe weiterer üblicher Zusätze enthalten, z. B. Inhibitoren zur Verhinderung der thermischen Polymerisation von Monomeren, Wasserstoffdonatoren, sensitometrische Regler, Verlaufshilfsmittel, Indikatoren, Farbstoffe, Farbpigmente und ungefärbte Pigmente. Die Summe aller Komponenten soll 100 % ergeben. Diese Bestandteile sind zweckmäßig so auszuwählen, daß sie in dem für den Initiierungsvorgang wichtigen aktinischen Strahlungsbereich möglichst nicht zu stark absorbieren. Als aktinische Strahlung soll jede Strahlung verstanden werden, deren Energie mindestens der des kurzwelligen sichtbaren Lichts entspricht. Geeignet ist insbesondere langwellige UV -Strahlung, aber auch Elektronen-, Röntgen- und Laserstrahlung. Die Herstellung der Reproduktionsschichten erfolgt in bekannter Weise. So kann man die Komponenten in einem Lösemittel aufnehmen und die Lösung bzw. Dispersion durch Gießen, Sprühen, Tauchen oder Antragen mit Walzen auf den vorgesehenen Träger als Film aufbringen und anschließend trocknen. Die Reproduktionsschichten werden in bekannter Weise belichtet und entwickelt. Als Entwickler sind wäßrige, vorzugsweise wäßrig-alkalische Lösungen, z. B. von Alkaliphosphaten oder Alkalisilikaten, geeignet, denen gegebenenfalls kleine Mengen an mischbaren organischen Lösemitteln und Netzmitteln zugesetzt werden können.

Die erfindungsgemäßen Copolymeren führen insbesondere in Kombination mit den erwähnten Fluoralkylgruppen enthaltenden strahlungsempfindlichen Verbindungen bzw. Systemen zu homogenaussehenden, gut-haftenden Reproduktionsschichten von hoher Strahlungsempfindlichkeit, die meistens in

wäßrig-alkalischen Lösungen entwickelt werden können und ausgezeichnete Farbabstoßung bewirken. Es ist überraschend, daß die erfindungsgemäßen Copolymeren auch bei einem Gehalt an fluorhaltigen Monomeren von 10 bis 20 % noch farbabstoßend sein können. Besonders überraschend ist es, daß die erfindungsgemäßen, phenolische OH-Gruppen enthaltenden Copolymeren bei Einsatz als Bindemittel auch in Reproduktionsschichten von Photopolymerdruckplatten hoher Strahlungsempfindlichkeit eingesetzt werden können, obwohl man annimmt, daß an sich phenolische OH-Gruppen als Radikalfänger eher als Polymerisationsinhibitoren anzusehen sind.

Die erfindungsgemäßen Reproduktionsschichten eignen sich besonders in Form eines vorsensibilisierten Kopiermaterials auf einem geeigneten Träger, z. B. aus Aluminium, Polyester oder Zink, für die photomechanische Herstellung von Offsetdruckformen für den wasserlosen Offsetdruck. Das Trägermaterial aus z. B. Aluminium kann auch durch mechanische, chemische und/oder elektrochemische Aufrauhung und gegebenenfalls einer nachfolgenden anodischen Oxidation an der Oberfläche modifiziert werden.

Werden Trägermaterialien nur mit einem oder mehreren der Copolymere und gegebenenfalls weiteren davon verschiedenen Bindemitteln beschichtet, so zeigen auch diese Schichten bei guter mechanischer Stabilität ausgezeichnete Wasser- und Farbabstoßung. Auch auf solchen beschichteten Materialien lassen sich - wie auch bereits aus dem Stand der Technik bekannt - durch mechanische, elektrische oder chemische Zerstörung von Teilen des Fluorpolymerfilms oder durch Betonerung oder Beschriftung Bildstellen erzeugen, die dann Farbe annehmen können, so daß auch von solchen modifizierten Materialien gegebenenfalls gedruckt werden kann.

In den nachfolgenden Beispielen und im vorstehenden Text verhalten sich Gew.-Teile zu Vol.-Teilen wie g zu $cm^3$ und %-Angaben sind - wenn nichts anderes angegeben ist - auf das Gewicht bezogen.

<u>Beispiel 1</u> [Synthese einer Monomeren-Komponente (a) der allgemeinen Formel (VII)]

Es werden 69 Gew.-Teile 3-Hydroxybenzoesäure (0,5 Mol), 142,5 Gew.-Teile Glycidylmethacrylat (1 Mol) und 1,5 Gew.-Teile Triethylbenzylammoniumchlorid während 1 h auf 80°C erwärmt. Danach werden weitere 60 Gew.-Teile der 3-Hydroxybenzoesäure zugegeben, und das Gemisch wird noch während 7 h bei 80°C belassen. Das Reaktionsprodukt wird in 190 Gew-Teilen warmem Ethanol gelöst und mit 0,15 Gew.-Teilen Hydrochinonmonomethylether stabilisiert.

<u>Beispiel 2</u> (Copolymerisation)

In einem Mehrhalskolben, der mit Kühler, Thermometer, Rührer und Zulaufgefäß ausgerüstet ist, werden 40 Vol.-Teile Butanon-2 unter Stickstoffüberlagerung auf 70°C erwärmt. Im Verlauf von 3 h wird ein Gemisch aus 24 Gew.-Teilen Methacrylsäure/3-Hydroxybenzoesäure-Glycerinester (entsprechend 40 Gew.-Teilen einer ethanolischen Lösung des Reaktionsprodukts des Beispiels 1), 36,4 Gew.-Teilen 1,1,2,2-Tetrahydroperfluordecylacrylat, 0,48 Gew.-Teilen Azoisobuttersäurenitril, 120 Vol.-Teilen Butanon-2 zugetropft, und danach wird noch während 7 h copolymerisiert. Unter heftigem Rühren wird diese Lösung in 10 000 Vol.-Teile Wasser eingetropft. Der sich bildende weiße, pulverige Niederschlag wird abgesaugt, gewaschen und während 6 h im Vakuum und anschließend noch 48 h bei 60°C im Umlufttrockenschrank getrocknet.

<u>Beispiele 3 bis 12 und Vergleichsbeispiel V1</u>

Es wird prinzipiell nach den Angaben im Beispiel 2 verfahren, die übrigen Verfahrensparameter und die Charakterisierung des Endprodukts sind der Tabelle I zu entnehmen. In der Tabelle bedeuten Tg die Glastemperatur (gemessen mit einem Differentialthermoanalysegerät), Tm den Schmelzbereich (gemessen auf einer Heizplatte), Tz die Zersetzungstemperatur und σ die Oberflächenspannung. Die Polymeren der Beispiele 6 bis 10 lösen sich in Butanon-2, bei denen des Beispiels 12 und des Vergleichsbeispiels V1 (reines Homopolymerisat) nimmt die Löslichkeit deutlich ab. Die Farbabstoßung der Polymeren in der Versuchsreihe 6 bis 12 und V1 ist gut bei den Beispielen 7 bis 12, und im Beispiel 6 sowie im Vergleichsbeispiel V1 eher mäßig.

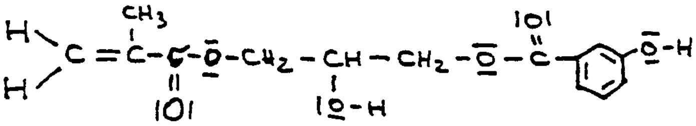

(i)

+

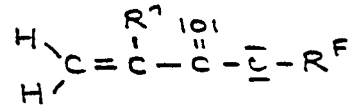

(ii)

**Tabelle I**

| Beispiel | Monomere | | | | Polymeres | | | | |
|---|---|---|---|---|---|---|---|---|---|
| | $R^1$ | $R^F$ | i/ii (%) | % F | Ausb. (%) | % F | Tg(°C) / Tm(°C) | Tz(°C) | σ (mN/n) |
| 2 | H | $C_8F_{17}C_2H_4$ | 40/60 | 37,4 | 96 | 37,8 | 59/115-130 | >300 | 9,9 |
| 3 | H | $C_6F_{13}C_2H_4$ | 40/60 | 35,5 | 95 | 35,9 | 52/- | >270 | 11,5 |
| 4 | H | $C_{8,5}F_{18}$*) $C_2H_4$ | 40/60 | 37,8 | 95 | 38,3 | 59/120-135 | >280 | 13,7 |
| 5 | $CH_3$ | $C_6F_{13}C_2H_4$ | 40/60 | 34,3 | 93 | 34,0 | 35/120-135 | >240 | - |
| 6 | H | $C_{7,5}F_{16}$*) $C_2H_4$ | 90/10 | 12,6 | 95 | - | 73/150-170 | 256 | - |
| 7 | H | " | 70/30 | 18,9 | 93 | 19,6 | 68/150-170 | 272 | 14,3 |
| 8 | H | " | 60/40 | 25,2 | 93 | 26,2 | 66/120-140 | 255 | 14,3 |
| 9 | H | " | 50/50 | 31,5 | 98 | 32,4 | 63/130-150 | 301 | 13,8 |
| 10 | H | " | 40/60 | 37,8 | 95 | 38,3 | 59/120-135 | 283 | 13,6 |
| 11 | H | " | 30/70 | 44,1 | 95 | 44,3 | 55/115-135 | 297 | - |
| 12 | H | " | 20/80 | 50,4 | 95 | 51,0 | 47/100-115 | >300 | - |
| V1 | H | " | 100/0 | 63,0 | 88 | - | 48/80-90 | >300 | - |

*) mittlere Anzahl von C-Atomen, da Gemisch verschiedener Perfluoralkylgruppen

Beispiel 13 [Synthese einer Monomeren-Komponente (b) der allgemeinen Formel (III)]

Es werden zu 36,4 Gew.-Teilen 1,1,2,2-Tetrahydro-perfluoroctanol-1 (0,1 Mol) und 0,5 Gew.-Teilen Tetrabutylammoniumhydrogensulfat in 200 Vol.-Teilen Tetrahydrofuran 40 Gew.-Teile einer 50 %-igen wäßrigen NaOH-Lösung gegeben und durch kräftiges Rühren während 15 min equilibriert. Danach werden 15,3 Gew.-Teile Vinylbenzylchlorid (0,1 Mol) während 1 h zugetropft, und das Gemisch wird während 5 h bei 40° C gerührt. Nach Zugabe von 10 Gew.-Teilen $K_2CO_3$ und 1 Gew.-Teil 18-Krone-6-ether wird während weiterer 7 h auf 60° C erhitzt. Die organische Phase wird von der wäßrigen getrennt, sie wird zweimal mit je 50 Vol.-Teilen einer gesättigten wäßrigen KCl-Lösung ausgeschüttelt und mit 500 Vol.-Teilen Methylenchlorid verdünnt, zweimal mit Wasser ausgeschüttelt, mit $MgSO_4$ getrocknet und von diesem abfiltriert. Nach Zugabe von 0,05 mg 4-Methoxyphenol als Polymerisationsinhibitor werden die organischen Lösemittel am Rotationsverdampfer abdestilliert und der Rückstand im Vakuum bei 0,25 mmHg (33,3 Pa) destilliert. Die Fraktion bei 100° C ist nach $^1H$- und $^{19}F$-NMR-Spektren das Perfluorhexyl-ethoxymethylstyrol.

Beispiel 14 [Synthese einer Monomeren-Komponente (b) der allgemeinen Formel (III)]

Es werden 232 Gew.-Teile 1,1,2,2-Tetrahydro-perfluordecanol-1 (0,5 Mol) und 2,5 Gew.-Teile Triethylbenzylammoniumhydrogensulfat in 500 Vol.-Teilen Tetrahydrofuran gelöst, wozu ein Gemisch aus 37 Gew.-Teilen $K_2CO_3$ und 33 Gew.-Teilen KOH (jeweils gepulvert) zugegeben wird.

Unter Rühren gibt man dann 76,5 Gew.-Teile (0,5 Mol) Vinylbenzylchlorid zu und rührt das Gemisch 8 h bei Raumtemperatur. Nach 48stündigem Stehenlassen wird während 8 h auf 66°C unter Rühren erwärmt. Nach weiterem 6stün-digem Stehenlassen bei Raumtemperatur wird vom Bodensatz abdekantiert und dieser zweimal mit THF gewaschen. Die vereinigten THF-Lösungen werden mit einer gesättigten, wäßrigen KCl-Lösung ausgeschüttelt, die THF-Phase mit $MgSO_4$ getrocknet, filtriert und mit 0,1 Gew.-Teil 4-Methoxyphenol stabilisiert. Nach Abdestillieren des organischen Lösemittels am Rotationsverdampfer wird der Rückstand im Vakuum destilliert. Hinter einer aus unumgesetztem Perfluoralkanol bestehenden Fraktion geht bei 66,7 Pa (0,5 mmHg) das gewünschte Perfluoroctyl-ethoxy-methylstyrol zwischen 118 und 125° C über.

Beispiele 15 und 16 (Copolymerisation)

In Anlehnung an Beispiel 2 werden die Produkte der Beispiele 13 und 14 mit dem Glycerinester des Beispiels 2 copolymerisiert:

(i) + 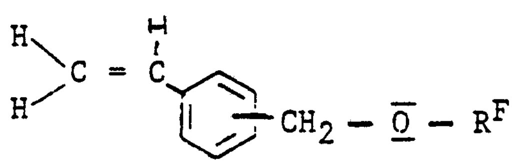 (iii)

Beispiele 17 und 18 (Copolymerisation)

In Anlehnung an Beispiel 2 werden Perfluoralkylgruppen enthaltende Acrylester [$R^1$ = H in der allgemeinen Formel (II)] mit einem Acrylsäure/2-Hydroxybenzoesäure-Ethylen-glykolester copolymerisiert:

(ii) + 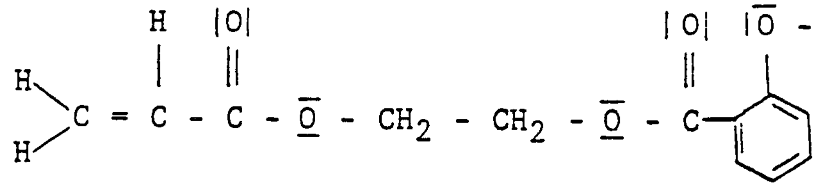 (ia)

**Tabelle II**

| Beispiel | Monomere | | | | Polymeres | | | |
|---|---|---|---|---|---|---|---|---|
| | $R^F$ | i/iii (%) | ia/ii (%) | % F | Ausb. (%) | % F | Tg (°C) | Tm (°C) |
| 15 | $C_6F_{13}C_2H_4$ | 70/30 | - | 36,1 | 88 | 36,1 | 32 | - |
| 16 | $C_8F_{17}C_2H_4$ | 60/40 | - | 33,4 | 91 | 33,9 | - | - |
| 17 | $C_{8,5}F_{18}C_2H_4$ | - | 40/60 | 37,8 | 96 | 37,9 | 16 | 50-70 |
| 18 | $C_8F_{17}C_2H_4$ | - | 40/60 | 37,4 | 97 | 37,1 | 16 | 50-70 |

Beispiel 19 (Anwendungsbeispiel)

Die erfindungsgemäßen Polymeren der Beispiele 2 bis 12 und 15 bis 18 werden jeweils in Butanon-2 bzw. einem Gemisch aus Butanon-2 und 1-Methoxy-propanol-2 gelöst und auf eine aufgerauhte Aluminiumfolie aufgeschleudert, während 1 bis 2 min mit einem Gebläse getrocknet und dann während 1 min bei 100°C im Trockenschrank getrocknet. Die Platten werden mit einer im Handel erhältlichen Druckfarbe für den wasserlosen Offsetdruck eingewalzt und zeigen eine sehr gute bis gute Farbabstoßung, sie waren praktisch tonfrei (Polymere der Beispiele 2, 4, 5, 7 bis 9 und 15 bis 18) bzw. zeigten sehr wenig Ton (Polymere der Beispiele 3, 6 und 10 bis 12). Bei sich anschließenden Druckversuchen, in denen von beschichteten Aluminiumteststücken neben unbeschichteten auf einer Druckmaschine bei abgeschaltetem Feuchtwerk gedruckt wurde, ergaben sich vergleichbare Ergebnisse.

Beispiele 20 bis 37 (Anwendungsbeispiele)

Die in den Beispielen 2 bis 18 synthetisierten Produkte können als organisches polymeres Bindemittel im Gemisch mit einem polymerisierbaren Monomeren oder Oligomeren, einem Photoinitiator und einem Farbstoff zu einer Reproduktionsschicht verarbeitet werden. Dazu wird im Regelfall eine Lösung oder Dispersion der Komponenten in einem organischen Lösemittel (Butanon-2 oder 1-Methoxy-Propanol-2) hergestellt und auf ein Trägermaterial wie eine elektrochemisch aufgerauhte Aluminiumfolie oder eine Polyesterfolie aufgebracht. Anschließend wird die strahlungsempfindliche Beschichtung getrocknet. Zur Verhinderung der Sauerstoffdiffusion wird auf die Reproduktionsschicht eine Deckschicht aus Polyvinylalkohol aufgebracht.

Die so vorbereiteten Offsetdruckplatten werden mit einer Metallhalogenidlampe (5 kW) im Abstand von 100 cm zwischen Lampe und Vakuumkopierrahmen durch eine Positivvorlage hindurch während 20 bis 150 sec belichtet. Die Entwicklung des belichteten Materials kann meist mit einer 3 %-igen wäßrigen $Na_2SiO_3$-Lösung (E1) durchgeführt werden. Nach Abwaschen mit Wasser und einer kurzen Trocknung bei 100°C kann mit den so hergestellten Druckformen trocken (d. h. unter Abschalten des Feuchtwerks einer Druckmaschine) mit käuflichen Spezialfarben für dem wasserlosen Offsetdruck gedruckt werden. Die farbannehmenden Stellen sind Teile der Oberfläche des Trägermaterials, die farbabstoßenden Stellen die stehengebliebenen Teile der Reproduktionsschicht.

Als Photoinitiator wird in allen Beispielen 2-(4-Ethoxy-naphth-1-yl)-4,6-bis-trichlormethyl-s-triazin eingesetzt, als polymerisierbare Verbindung eines der in der Beschreibung genannten, in der EP-A-167 779 erstmals beschriebenen Perfluoralkylgruppen enthaltenden Monomeren oder Oligomeren, diese sind

PM1 (Umsetzungsprodukt aus Pentaerythrittriacrylat und einem Gemisch aus 2,2-Dihydro-perfluoralkansäurechloriden mit 8 bis 14 Kohlenstoffatomen

PM2 (Veresterungsprodukt aus einem Umsetzungsprodukt aus einem Perfluoralkanol und Benzophenontetracarbonsäureanhydrid mit dem Methacrylsäureester des 1,2 Epoxy-propanols-3)

PO1 (Oligomeres aus PM2 und Hexan-1,6-diisocyanat)

PO2 (Oligomeres aus PM2 und Toluol-1,4-diisocyanat)

Als Beurteilungskriterien für die Reproduktionsschicht dienen die Beschichtungsqualität (G = gut, B = befriedigend, M = mäßig, S = schlecht) durch visuelle Beurteilung vor der Bestrahlung, Entwicklung und Einfärbung und nach diesen Verfahrensstufen die Anzahl der freien bzw. gedeckten Stufen in einem Halbtonstufenkeil mit 13 Stufen einer Keilkonstante (Dichteabstufung) von 0,15 (z. B. Belichtungstestkeil

"BKO1" der Firma KALLE Niederlassung der Hoechst AG) und die Wiedergabe von feinsten Bildelementen in einem 12stufigen Rasterkeil mit 60er Raster, beginnend mit einem Tonwert von 5 % in Stufe 1 und endend mit einem Tonwert von 95 % in Stufe 12 (z. B. Rasterkeil "RKO1" der Firma KALLE Niederlassung der Hoechst AG); bei der Anwendung des Rasterkeils sind einerseits in der Tabelle die Anzahl der Felder angegeben, die noch Farbe abstoßen (v) (d. h. Nichtbildstellen aufweisen) und andererseits das Feld, das erstmals Farbe annimmt (w).

Das Polymere des Beispiels 6 zeigt noch keine ausreichende Farbabstoßung, während die Polymere der Beispiele 12 und V1 keine vollständig bzw. nicht mehr rein wäßrig-alkalisch aufentwickelbare Reproduktionsschichten ergeben, so daß die Bildstellen nicht sehr gut Farbe annehmen (Beispiele 26 und 27).

**Tabelle III**

| Komponenten, Behandlungsmittel, Beurteilung | | Gew.-Teile der Komponenten (bzw. andere Parameter) im Beispiel | | | | |
|---|---|---|---|---|---|---|
| | | 20 | 21 | 22 | 23 | 24 |
| polymerisierbares Monomeres bzw. Oligomeres | PM1 | 1,0 | 1,0 | 1,0 | 1,0 | 1,0 |
| | PO1 | 0,5 | 0,5 | 0,5 | 0,5 | 0,5 |
| | PO2 | | | | | |
| Als Bindemittel Polymeres des | Bsp. 2 | | | | | |
| | 3 | | | | | |
| | 4 | | | | | 1,0 |
| | 5 | | | | | |
| | 6 | 1,0 | | | | |
| | 7 | | 1,0 | | | |
| | 8 | | | 1,0 | | |
| | 10 | | | | 1,0 | |
| | 11 | | | | | |
| | 12 | | | | | |
| | V1 | | | | | |
| | 15 | | | | | |
| | 16 | | | | | |
| Photoiniator | | 0,05 | 0,05 | 0,05 | 0,05 | 0,05 |
| Farbstoff | | 0,02 | 0,02 | 0,02 | 0,02 | 0,02 |
| Butanon-2 | | 15 | 15 | 15 | 15 | 15 |
| Beschichtungsqualität | | S | G | G | G | G |
| Belichtungszeit (sec) | | 50 | 50 | 50 | 50 | 50 |
| Entwickler | | E1 | E1 | E1 | E1 | E1 |
| Entwicklungszeit (min) | | 0,5 | 1,0 | 1,5 | 1,5 | 1,5 |
| Halbtonstufenkeil (x/y) *) | | 0/4 | 4/5 | 6/7 | 4/6 | 6/8 |
| Rasterkeil (v/w) | | 8/2 | 10/3 | 12/2 | 12/2 | 12/3 |

*) x = Anzahl der vollgedeckten Stufen
y = Summe von vollgedeckten und teilgedeckten Stufen

| | | 25 | 26 | 27 | 28 | 29 |
|---|---|---|---|---|---|---|
| polymerisierbares Monomeres bzw. Oligomeres | PM1 | 1,0 | 1,0 | 1,0 | 1,0 | 1,0 |
| | PO1 | 0,5 | 0,5 | 0,5 | 0,5 | 0,5 |
| | PO2 | | | | | |
| Als Bindemittel Polymeres des | Bsp. 2 | | | | | |
| | 3 | | | | | |
| | 4 | | | | 1,0 | 1,0 |
| | 5 | | | | | |

| | | | | | | | |
|---|---|---|---|---|---|---|---|
| | | 6 | | | | | |
| | | 7 | | | | | |
| | | 8 | | | | | |
| | | 10 | | | | | |
| | | 11 | 1,0 | | | | |
| | | 12 | | 1,0 | | | |
| | | V1 | | | 1,0 | | |
| | | 15 | | | | | |
| | | 16 | | | | | |
| Photoinitiator | | | 0,05 | 0,05 | 0,05 | 0,05 | 0,05 |
| Farbstoff | | | 0,02 | 0,02 | 0,02 | 0,02 | 0,02 |
| Butanon-2 | | | 15 | 15 | 15 | 15 | 15 |
| Beschichtungsqualität | | | M | S | S | G | G |
| Belichtungszeit (sec) | | | 50 | 50 | 50 | 50 | 50 |
| Entwickler | | | E1 | E1 | E1 | E1 | E1 |
| Entwicklungszeit (min) | | | 2,0 | >2,0 | >5,0 | 1,5 | 1,5 |
| Halbtonstufenkeil (x/y) | | | 6/8 | 12/13 | 12/- | 7/10 | 5/7 |
| Rasterkeil (v/w) | | | 11/4 | - | - | 12/3 | 11/2 |

| | | | 30 | 31 | 32 | 33 | 34 |
|---|---|---|---|---|---|---|---|
| polymerisierbares | PM1 | | 0,5 | 1,0 | 0,5 | 1,0 | 1,0 |
| Monomeres bzw. | PO1 | | 0,5 | 0,5 | 0,5 | 0,5 | |
| Oligomeres | PO2 | | | | | | 0,5 |
| Als Bindemittel | Bsp. | 2 | 1,0 | 1,0 | | | |
| Polymeres des | | 3 | | | 1,0 | 1,0 | |
| | | 4 | | | | | |
| | | 5 | | | | | 1,0 |
| | | 6 | | | | | |
| | | 7 | | | | | |
| | | 8 | | | | | |
| | | 10 | | | | | |
| | | 11 | | | | | |
| | | 12 | | | | | |
| | | V1 | | | | | |
| | | 15 | | | | | |
| | | 16 | | | | | |
| Photoinitiator | | | 0,05 | 0,05 | 0,05 | 0,05 | 0,05 |
| Farbstoff | | | 0,02 | 0,02 | 0,02 | 0,02 | 0,02 |
| Butanon-2 | | | 15 | 15 | 15 | 15 | 15 |
| Beschichtungsqualität | | | G | G | G | G | M |
| Belichtungszeit (sec) | | | 50 | 50 | 50 | 50 | 50 |
| Entwickler | | | E1 | E1 | E1 | E1 | E1 |
| Entwicklungszeit (min) | | | 1,5 | 1,5 | 1,5 | 1,5 | 1,5 |
| Halbtonstufenkeil (x/y) | | | 8/13 | 10/12 | 8/10 | 10/12 | 7/9 |
| Rasterkeil (v/w) | | | 12/3 | 12/3 | 11/2 | 12/3 | 12/3 |

| | | 35 | 36 | 37 |
|---|---|---|---|---|
| polymerisierbares | PM1 | 1,0 | 1,0 | 1,0 |
| Monomeres bzw. | PO1 | | 0,5 | 0,5 |
| Oligomeres | PO2 | 0,5 | | |
| Als Bindemittel | Bsp. 2 | 1,0 | | |
| Polymeres des | 3 | | | |
| | 4 | | | |
| | 5 | | | |
| | 6 | | | |
| | 7 | | | |
| | 8 | | | |
| | 10 | | | |
| | 11 | | | |
| | 12 | | | |
| | V1 | | | |
| | 15 | | 1,0 | |
| | 16 | | | 1,0 |
| Photoinitiator | | 0,05 | 0,05 | 0,05 |
| Farbstoff | | 0,02 | 0,02 | 0,02 |
| Butanon-2 | | 15 | 15 | 15 |
| Beschichtungsqualität | | M | M | M |
| Belichtungszeit (sec) | | 50 | 50 | 50 |
| Entwickler | | E1 | E1 | E1 |
| Entwicklungszeit (min) | | 1,5 | 2,0 | 1,5 |
| Halbtonstufenkeil (x/y) | | 5/8 | 10/12 | 11/13 |
| Rasterkeil (v/w) | | 12/2 | 5/4 | 12/4 |

**Patentansprüche**

1. Perfluoralkylgruppen enthaltende Copolymere, hergestellt aus mindestens zwei unterschiedlichen Monomeren mit je einer polymerisierbaren endständigen ethylenisch-ungesättigten Gruppe, wobei eines der beiden Monomeren eine Perfluoralkyl- oder Fluoralkenylgruppe aufweist, dadurch gekennzeichnet, daß

(a) 10 bis 90 Gew.-%, bezogen auf die Gesamtmenge an Monomeren, Acryloyl- oder Methacryloylgruppen und phenolische OH-Gruppen enthaltende Monomere der allgemeinen Formel (I)

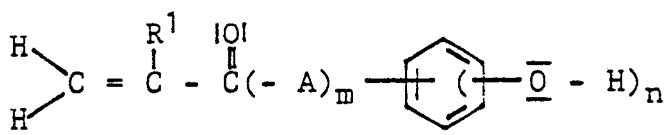

(I)

in der $R^1$ = H oder $Ch_3$; n = 1, 2 oder 3; m = 0 oder 1 und

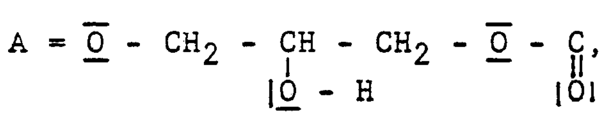

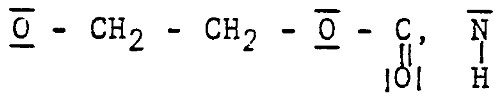

oder

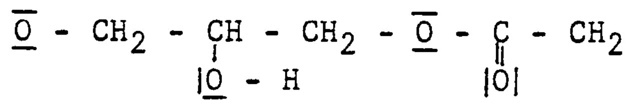

bedeuten und

(b) 90 bis 10 Gew.-%, bezogen auf die Gesamtmenge an Monomeren, Acryloyloxy-, Methacryloyloxy- oder Vinylgruppen und eine Perfluoralkylgruppe enthaltende Monomere der allgemeinen Formeln (II) oder (III)

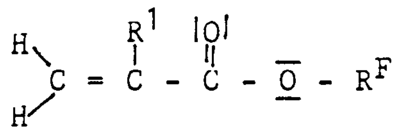

(II)

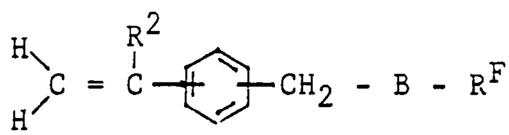

(III)

in denen $R^2$ = H oder Alkyl von $C_1$ bis $C_5$, B = Ō oder

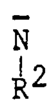 , $R^F = F(C_wF_{2w})(-CH_2)_z$

oder

$F(C_{w-1}F_{2w-2}) - CF = CH$, wobei die Difluormethylengruppen gegebenenfalls auch über Etherbrücken verknüpft sein können, w = 5 bis 15 und z = 0 bis 5 bedeuten und $R^1$ die unter (a) angegebene Bedeutung hat, copolymerisiert worden sind.

2. Copolymere nach Anspruch 1, dadurch gekennzeichnet, daß in der allgemeinen Formel (I) m = 1,

A = 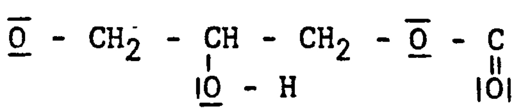 und n = 1 bedeuten.

3. Copolymere nach Anspruch 1 oder 2, dadurch gekennzeichnet, daß in den allgemeinen Formeln (II) und (III) w = 6 bis 12, z = 0 bis 2, $R^2$ = H und B = Ō bedeuten.

4. Copolymere nach einem der Ansprüche 1 bis 3, dadurch gekennzeichnet, daß 20 bis 80 Gew.-% der Monomeren-Komponente (a) mit 80 bis 20 Gew.-% der Monomeren-Komponente (b) copolymerisiert worden sid.

5. Verfahren zur Herstellung der Copolymeren nach einem der Ansprüche 1 bis 4, in denen m = 1,

A = 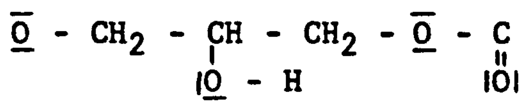

oder

$$\overline{O} - CH_2 - CH_2 - \overline{O} - \underset{|\overline{O}|}{\overset{}{C}},\ w = 6 \text{ bis } 12,\ z = 0 \text{ bis } 2,$$

$R^2$ = H und B = $\underline{O}$ bedeuten, dadurch gekennzeichnet, daß eine Hydroxybenzoesäure der allgemeinen Formel (IV) mit einem Hydroxyalkylacrylat oder Glycidylacrylat bzw. dem entsprechenden Methacrylat der allgemeinen Formeln (V) und (VI) verestert wird

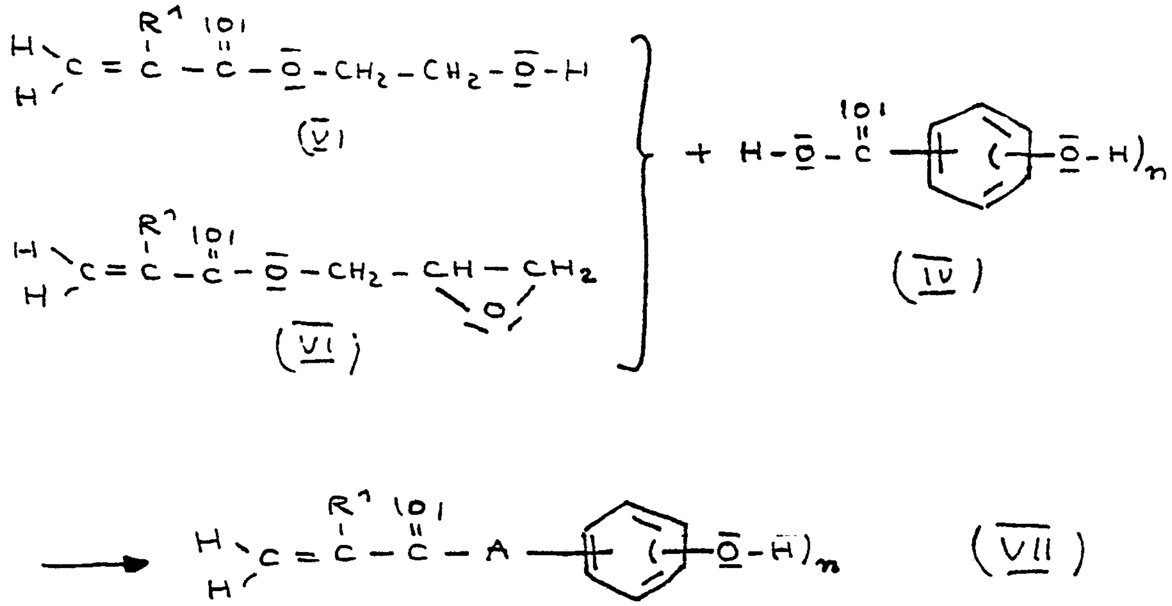

(V) (VI) (IV) (VII)

und der entstehende Ester der allgemeinen Formel (VII) als Monomeren-Komponente (a) mit der Monomeren-Komponente (b) copolymerisiert wird.

6. Strahlungsempfindliche Reproduktionsschicht mit einem Gehalt an (c) mindestens einer strahlungsempfindlichen Verbindung und (d) mindestens einem organischen polymeren Bindemittel, dadurch gekennzeichnet, daß die Komponente (d) ein Copolymeres gemäß einem der Ansprüche 1 bis 4 ist.

7. Reproduktionsschicht nach Anspruch 6, dadurch gekennzeichnet, daß das Copolymere in wäßrig-alkalischen Lösungen löslich ist.

8. Reproduktionsschicht nach Anspruch 6 oder 7, dadurch gekennzeichnet, daß die Komponente (c) mindestens eine Verbindung enthält, die mindestens eine Perfluoralkylgruppe aufweist.

9. Reproduktionsschicht nach einem der Ansprüche 6 bis 8, dadurch gekennzeichnet, daß die Komponente (c) mindestens eine polymerisierbare, Perfluoralkylgruppen aufweisende Verbindung mit mindestens zwei endständigen ethylenisch-ungesättigten Gruppen und mindestens einen Photoinitiator enthält.

10. Reproduktionsschicht nach einem der Ansprüche 6 bis 8, dadurch gekennzeichnet, daß die Komponente (c) mindestens eine 1,2-Naphthochinondiazidverbindung enthält, die als Substituenten mindestens eine Perfluoralkylgruppe aufweist.

11. Verwendung einer Reproduktionsschicht nach den Ansprüchen 6 bis 10 als strahlungsempfindliche Beschichtung von Druckplattenträgermaterialien für den wasserlosen Offsetdruck.

## Claims

1. Copolymers containing perfluoroalkyl-groups, prepared from at least two different monomers comprising, in each case, a polymerizable ethylenically unsaturated end group and one of the two monomers having a perfluoroalkyl or fluoroalkenyl group, wherein

(a) from 10 to 90 % by weight, based on the total amount of monomers, of monomers containing acryloyl or methacryloyl groups and phenolic OH groups and corresponding to the general formula (I)

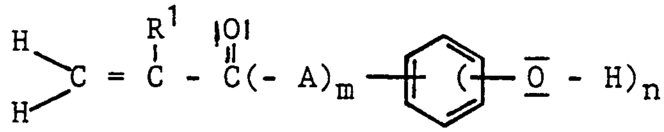

(I)

wherein $R^1 = H$ or $CH_3$; n = 1, 2, or 3; m = 0 or 1 and

A = 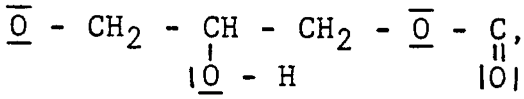,

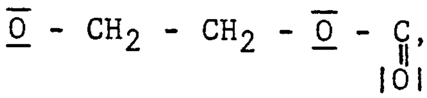, 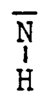 or

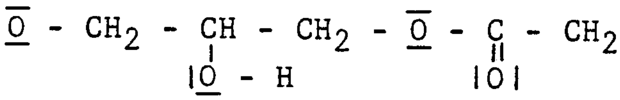 and

(b) from 90 to 10 % by weight based on the total amount of monomers, of monomers containing acryloyloxy, methacryloyloxy or vinyl groups and a perfluoroalkyl group and corresponding to the general formulae (II) or (III)

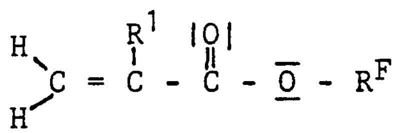

(II)

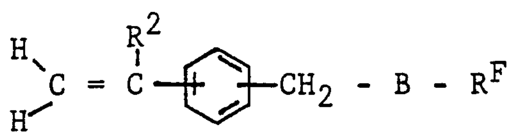

(III)

wherein $R^2 = H$ or alkyl from $C_1$ to $C_5$, B = |O| or 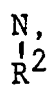,

$R^F = F(C_wF_{2w})(-CH_2)_z$ or $F(C_{w-1}F_{2w-2})-CF=CH$, the difluoromethylene groups optionally being linked by ether bridges, w = 5 to 15 and z = 0 to 5, and $R^1$ has the signification indicated under (a), have been copolymerized.

2. Copolymers as claimed in claim 1, wherein in the general formula (I) m = 1,

A = 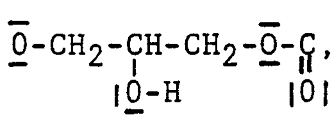,

and n = 1

3. Copolymers as claimed in claim 1 or claim 2, wherein in the general formulae (II) and (III)

w = 6 to 12,
z = 0 to 2,
$R^2 = H$, and
$B = \bar{O}$.

4. Copolymers as claimed in any of claims 1 to 3, wherein from 20 to 80 % by weight of monomer component (a) have been copolymerized with 80 to 20 % by weight of monomer component (b).

5. Process for preparing the copolymers as claimed in any of claims 1 to 4, with m = 1,

A = 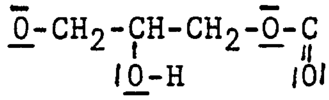 or

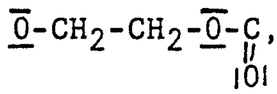

w = 6 to 12
z = 0 to 2
$R^2$ = H, and
$B = \bar{\underline{O}}$,

wherein a hydroxybenzoic acid of the general formula (IV) is esterified with a hydroxyalkyl acrylate, glycidyl acrylate or the corresponding methacrylate according to general formulae (V) and (VI)

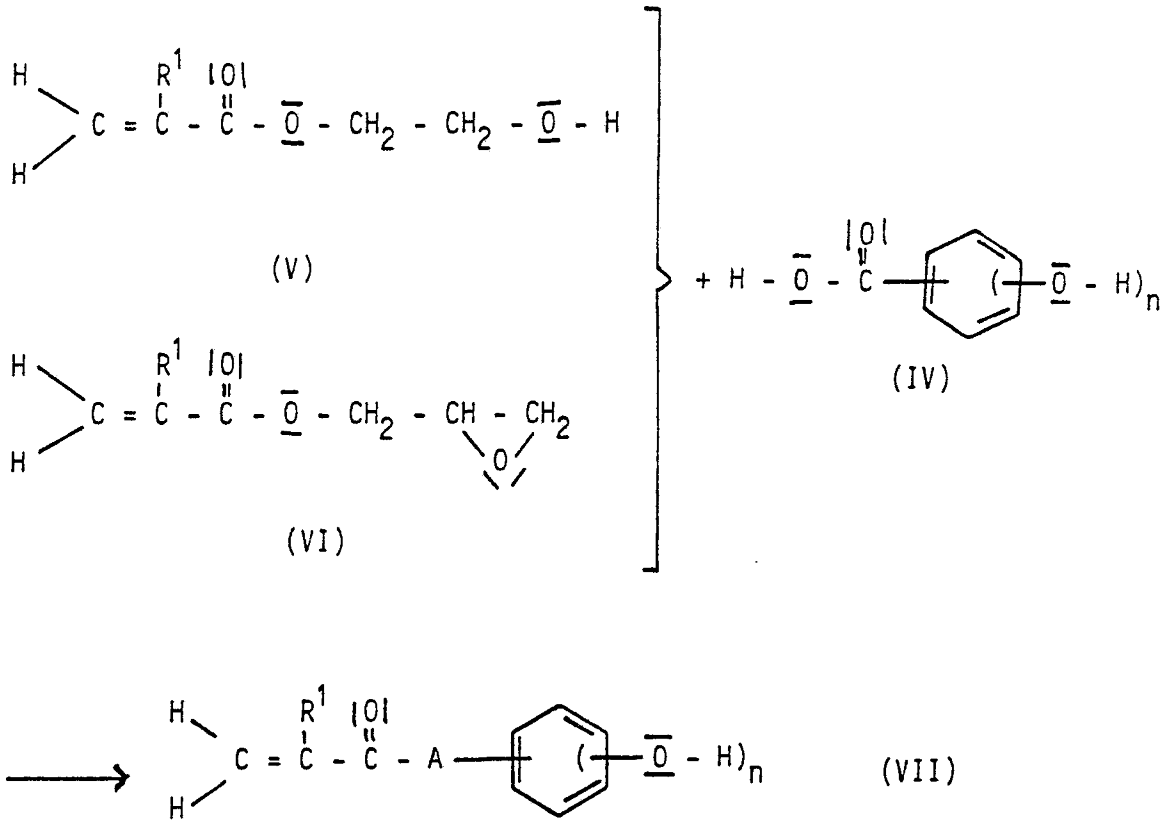

(V) (VI) (IV) (VII)

and the resulting ester of the general formula (VII) is copolymerized as monomer component (a) with monomer component (b).

6. Radiation-sensitive reproduction layer containing (c) at least one radiation-sensitive compound and (d) at least one organic polymeric binder, wherein component (d) comprises a copolymer as claimed in any of claims 1 to 4.

7. A reproduction layer as claimed in claim 6, wherein the copolymer is soluble in aqueous-alkaline solutions.

8. A reproduction layer as claimed in claim 6 or claim 7, wherein component (c) comprises at least one compound containing at least one perfluoroalkyl group.

9. A reproduction layer as claimed in any of claims 6 to 8, wherein component (c) comprises at least one polymerizable compound containing perfluoroalkyl groups and having at least two ethylenically unsaturated end groups and at least one photoinitiator.

10. A reproduction layer as claimed in any of claims 6 to 8, wherein component (c) comprises at least one 1,2-naphthoquinonediazide compound which has at least one perfluoroalkyl group as a substituent.

11. Use of a reproduction layer as claimed in claims 6 to 10, as a radiation-sensitive coating of support materials for printing plates used in waterless offset printing.

## Revendications

1. Copolymères contenant des groupes perfluoroalkyle, préparés à partir d'au moins deux monomères distincts comportant chacun un groupe polymérisable terminal à insaturation éthylénique, un des deux monomères comportant un groupe perfluoroalkyle ou fluoroalcényle, qui sont caractérisés en ce que

(a) de 10 à 90 % en poids, par rapport à la quantité total des monomères, de monomères contenant des groupes acryloyle ou méthacryloyle et des groupes OH phénoliques, de formule générale (I)

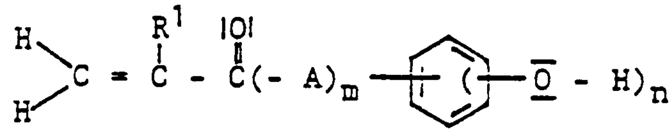

(I)

dans laquelle $R^1$ = H ou $CH_3$; n = 1, 2 ou 3; m = 0 ou 1;
et A représente

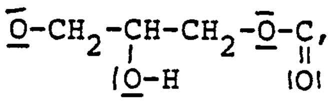, 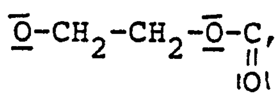, 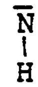

ou

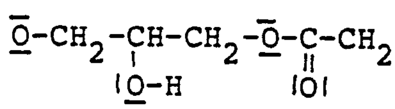,

et

(b) de 90 à 10 % en poids, par rapport à la quantité totale des monomères, de monomères contenant de groupes acryloyloxy, méthacryloyloxy ou vinyle et un groupe perfluoroalkyle, de formules générales (II) ou (III)

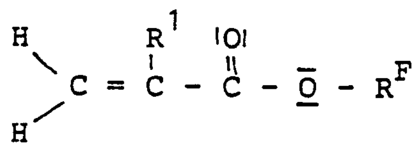

(II)

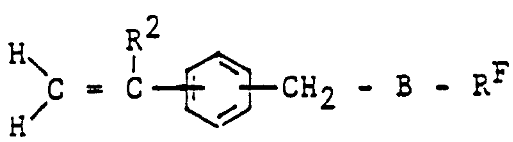

(III)

dans lesquelles $R^2$ représente H ou un groupe alkyle en $C_1$-$C_5$; B = $\bar{O}$ ou $\bar{N}R^2$; $R^F$ = $F(C_wF_{2w})(-CH_2)_z$ ou $F(C_{w-1}F_{2w-2})$-CF=CH, les groupes difluorométhylè e pouvant éventuellement être aussi reliés par des ponts éther; w = 5 à 15; et z = 0 à 5, et $R^1$ a la signification donnée en (a), ont été colomymérisés.

2. Copolymères selon la revendication 1, caractérisés en ce que, dans la formule générale (I), m = 1, A représente

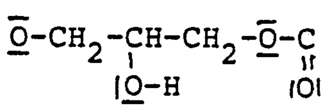 et n = 1.

3. Copolymères selon la revendication 1 ou 2, caractérisés en ce que, dans les formules générales (II) et (III), w = 6 à 12; z = 0 à 2; $R^2$ = H et B = $\bar{O}$.

4. Copolymères selon l'une des revendications 1 à 3, caractérisés en ce que de 20 à 80 % en poids du composant monomère (a) ont été copolymérisés avec de 80 a 20 % en poids du composant monomère (b).

5. Procédé pour la préparation des copolymères selon l'une des revendications 1 à 4, dans lesquels m = 1, A représente

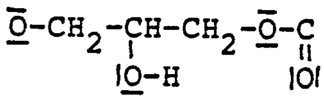 ou 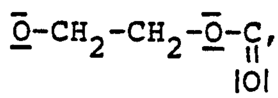, w = 6 à 12,

z = 0 à 2, $R^2$ = H et B = O, caractérisé en ce que l'on estérifie un acide hydroxybenzoïque de formule générale (IV) avec un acrylate d'hydroxyalkyle ou acrylate de glycidyle ou le méthacrylate correspondant, de formules générales (V) et (VI)

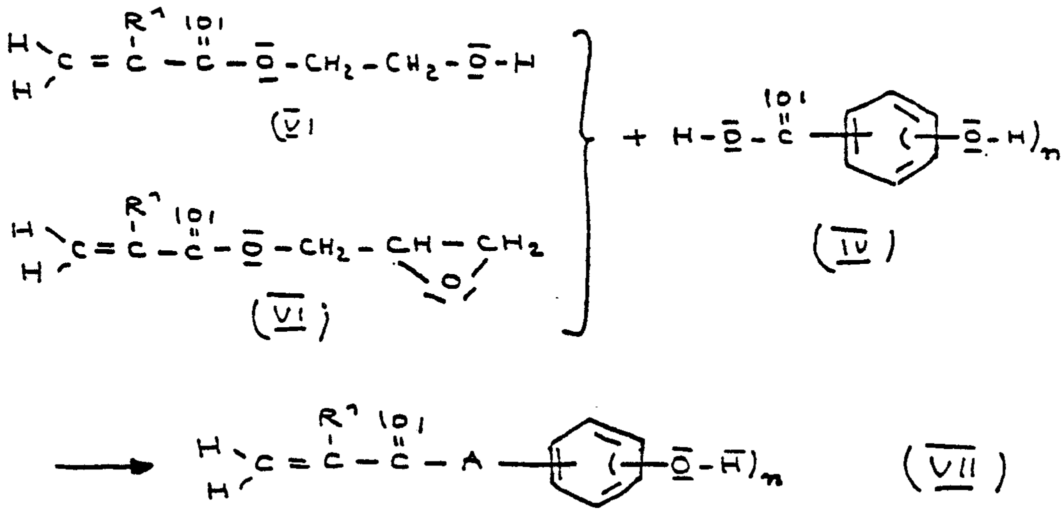

(V) (VI) (IV) (VII)

et on copolymérise avec le composant monomère (b) l'ester de formule générale (VII) résultant, en tant que composant monomère (a).

6. Couche de reproduction sensible aux radiations, ayant une teneur en (c) au moins un composé sensible aux radiations, et (d) au moins un liant polymère organique, caractérisée en ce que le composé (d) est un copolymère selon l'une des revendications 1 à 4.

7. Couche de reproduction selon la revendication 6, caractérisée en ce que le copolymère est soluble dans des solutions aqueuses alcalines.

8. Couche de reproduction selon la revendication 6 ou 7, caractérisée en ce que le composant (c) contient au moins un composé qui comporte au moins un groupe perfluoroalkyle.

9. Couche de reproduction selon l'une des revendications 6 à 8, caractérisée en ce que le composant (c) contient au moins un composé polymérisable comportant des groupes perfluoroalkyle et au moins deux groupes terminaux à insaturation éthylénique, et au moins un photoinitiateur.

10. Couche de reproduction selon l'une des revendications 6 à 8, caractérisée en ce que le composant (c) contient au moins un composé 1,2-naphtoquinonediazide qui comporte en tant que substituant au moins un groupe perfluoroalkyle.

11. Utilisation d'une couche de reproduction selon les revendications 6 à 10 en tant que revêtement, sensible aux radiations, de matériau de support pour plaques d'impression pour l'impression offset à sec.